# EUROPEAN PATENT APPLICATION

(11) **EP 4 769 379 A1**
(43) Date of publication of application: **01.07.2026**
(21) Application number: 25206865.5
(22) Date of filing: 06.10.2025
(51) Int. Cl.: G09G 3/3233

(54) **DISPLAY DEVICE**

(30) Priority: 26.12.2024 KR 20240197388
(71) Applicant: LG Display Co., Ltd., Seoul, 07336 (KR)
(72) Inventor: KO, Younghyun, 10845 Paju-si, Gyeonggi-do (KR); JANG, Jaeman, 10845 Paju-si, Gyeonggi-do (KR); CHOI, Sungju, 10845 Paju-si, Gyeonggi-do (KR); RYU, Jihee, 10845 Paju-si, Gyeonggi-do (KR)
(74) Representative: Viering, Jentschura & Partner mbB Patent- und Rechtsanwälte

(57) **Abstract**

Disclosed is a display device comprising a plurality of subpixels (SP1, SP2, SP3, SP4), a sensing control line (SCL) extending in a first direction between at least a first pair of subpixels among the plurality of subpixels (SP1, SP2, SP3, SP4) in a plan view of the display device, a reference line (RL) extending in a second direction crossing the first direction between at least a second pair of subpixels among the plurality of subpixels (SP1, SP2, SP3, SP4) in the plan view, and a plurality of sensing thin film transistors (T3, T31, T32, T33, T34) in the plurality of subpixels (SP1, SP2, SP3, SP4) and connected to the sensing control line (SCL) and the reference line (RL), wherein the plurality of sensing thin film transistors (T3, T31, T32, T33, T34) overlap the sensing control line (SCL) and the reference line (RL) in the plan view.

## Description

### BACKGROUND

### Technical Field

The present disclosure relates to a display device.

### Description of the Related art

A display device includes a plurality of signal lines and a plurality of thin film transistors connected to the plurality of signal lines.

The plurality of thin film transistors may include a switching thin film transistor, a driving thin film transistor, and a sensing thin film transistor provided in each of a plurality of subpixels.

As described above, since at least three thin film transistors are provided in each of the plurality of subpixels, a region for forming the thin film transistor is required, whereby there is a limitation in reducing the size of the subpixel.

### SUMMARY

The present disclosure has been made in view of the above problems, and an object of the present disclosure to provide a display device capable of reducing a region for forming a thin film transistor. According to an aspect of the present disclosure, a display device according to claim 1 is provided. Further embodiments are described in the dependent claims.

In accordance with an embodiment of the present disclosure, the above and other objects may be accomplished by the provision of a display device comprising: a plurality of subpixels; a sensing control line extending in a first direction, the sensing control line between at least a first pair of subpixels among the plurality of subpixels in a plan view of the display device; a reference line extending in a second direction that crosses the first direction, the reference line between at least a second pair of subpixels among the plurality of subpixels in the plan view; and a plurality of sensing thin film transistors included in the plurality of subpixels, the plurality of sensing thin film transistors connected to the sensing control line and the reference line, wherein the plurality of sensing thin film transistors overlap the sensing control line and the reference line in the plan view.

In one embodiment, a display device comprises: a pixel including a plurality of subpixels; a sensing control line extending in a first direction, the sensing control line between at least a first pair of subpixels among the plurality of subpixels in a plan view of the display device; a reference line extending in a second direction that crosses the first direction, the reference line between at least a second pair of subpixels among the plurality of subpixels in the plan view; and a plurality of sensing thin film transistors included in the plurality of subpixels, the plurality of sensing thin film transistors connected to the sensing control line and the reference line, wherein the plurality of sensing thin film transistors are located in a central portion of the pixel in the plan view.

In one embodiment, a display device comprises: a pixel including a plurality of subpixels; a sensing control line extending in a first direction and between at a first pair of subpixels among the plurality of subpixels in a plan view of the display device, the sensing control line including a first part, a third part, and a second part that is between the first part and the third part and connected to the first part and the third part; and a reference line extending in a second direction that crosses the first direction, the reference line between a second pair of subpixels among the plurality of subpixels in the plan view, wherein a width of the second part in the plan view is different from a width of the first part and a width of the third part in the plan view.

In addition to the effects of the present disclosure as mentioned above, additional advantages and features of the present disclosure will be clearly understood by those skilled in the art from the above description of the present disclosure.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a schematic view of an electroluminescent display device according to one embodiment of the present disclosure;
FIG. 2 is a circuit diagram of an electroluminescent display device according to one embodiment of the present disclosure;
FIG. 3 is a plan view of an electroluminescent display device according to one embodiment of the present disclosure;
FIG. 4 is a plan view of an electroluminescent display device which relates to an example of a region of a sensing thin film transistor of FIG. 3 according to one embodiment of the present disclosure;
FIG. 5 is a plan view of an electroluminescent display device which relates to another example of a region of a sensing thin film transistor of FIG. 3 according to another embodiment of the present disclosure;
FIG. 6 is a cross-sectional view of an electroluminescent display device taken along line A-A of FIGs. 4 and 5 according to one embodiment of the present disclosure;
FIG. 7 is a cross-sectional view of an electroluminescent display device taken along line B-B of FIGs. 4 and 5 according to one embodiment of the present disclosure;
FIG. 8 is a plan view of an electroluminescent display device which relates to another example of a region of a sensing thin film transistor of FIG. 3 according to another embodiment of the present disclosure;
FIG. 9 is a plan view of an electroluminescent display device which relates to another example of a region of a sensing thin film transistor of FIG. 3 according to another embodiment of the present disclosure;
FIG. 10 is a cross-sectional view of an electroluminescent display device which is a cross-sectional view taken along line A-A of FIGs. 8 and 9 according to another embodiment of the present disclosure;
FIG. 11 is a cross-sectional view of an electroluminescent display device which is a cross-sectional view taken along line B-B of FIGs. 8 and 9 according to another embodiment of the present disclosure;
FIG. 12 is a schematic view of an electroluminescent display device according to another embodiment of the present disclosure;
FIG. 13 is a plan view of an electroluminescent display device which relates to an example of a region of a sensing thin film transistor of FIG. 12 according to another embodiment of the present disclosure;
FIG. 14 is a plan view of an electroluminescent display device which relates to another example of a region of a sensing thin film transistor of FIG. 12 according to another embodiment of the present disclosure; and
FIG. 15 is a cross-sectional view of an electroluminescent display device which is a cross-sectional view taken along line C-C of FIGs. 13 and 14 according to another embodiment of the present disclosure.

### DETAILED DESCRIPTION

Advantages and features of the present disclosure, and implementation methods thereof will be clarified through the following embodiments, described with reference to the accompanying drawings. The present disclosure may, however, be embodied in different forms and should not be construed as being limited to the embodiments set forth herein. Rather, these embodiments are provided so that this disclosure will be thorough and complete, and will fully convey the scope of the present disclosure to those skilled in the art. Further, the present disclosure is only defined by the scope of the claims.

The shapes, sizes, ratios, angles, and numbers disclosed in the drawings for describing embodiments of the present disclosure are merely examples, and thus the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. In the case in which "comprise," "have," and "include" described in the present specification are used, another part may also be present unless "only" is used. The terms in a singular form may include plural forms unless noted to the contrary.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in a co-dependent relationship.

Hereinafter, preferred embodiments of the present disclosure will be described in detail with reference to the accompanying drawings.

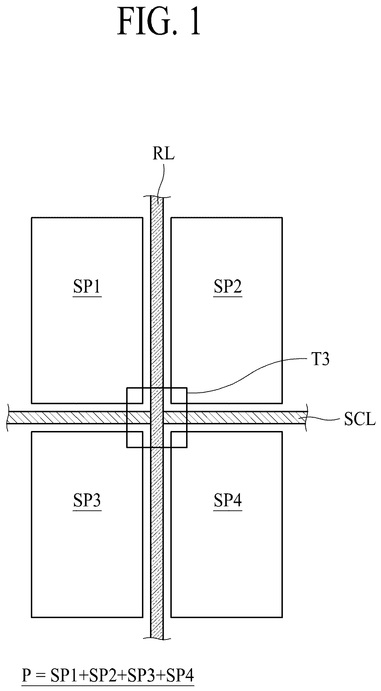

FIG. 1 is a schematic view of an electroluminescent display device according to one embodiment of the present disclosure.

As shown in FIG. 1, the electroluminescent display device according to one embodiment of the present disclosure includes a plurality of pixels P, wherein the pixel P indicates a basic unit for displaying an image.

The pixel P includes a first subpixel SP1, a second subpixel SP2, a third subpixel SP3, and a fourth subpixel SP4.

Each of the first to fourth subpixels SP1, SP2, SP3, and SP4 includes various signal lines, a capacitor, and thin film transistors for emitting light.

Among the first to fourth subpixels SP1, SP2, SP3, and SP4, three subpixels may include a red subpixel, a green subpixel, and a blue subpixel, and the other subpixel may include a white subpixel, any one subpixel of red, green, and blue, or a subpixel with a color different from red, green, and blue.

The first subpixel SP1 and the second subpixel SP2 may be arranged along a first direction in a first row, for example, a horizontal direction, and the third subpixel SP3 and the fourth subpixel SP4 may be arranged along the first direction in a second row that is adjacent to the first row without any intermediate row between the first row and the second row.

The first subpixel SP1 and the third subpixel SP3 may be arranged along a second direction crossing the first direction in a first column, for example, in a vertical direction, and the second subpixel SP2 and the fourth subpixel SP4 may be arranged along the second direction in a second column that is adjacent to the first column without any intermediate column between the first column and the second column.

A sensing control line SCL extends in the first direction between the first row and the second row. That is, the sensing control line SCL is between the first and third subpixels SP1 and SP3 and between the second and fourth subpixels SP2 and SP4. In other words, the sensing control line SCL is between a first pair of subpixels disposed along the horizontal direction (e.g., the first subpixel SP1 and the second subpixel SP2) and a second pair of subpixels disposed along the horizontal direction (e.g., the third subpixel SP3 and the fourth subpixel SP4). In one embodiment, the first subpixel SP1 and the second subpixel SP2 are at a first side of the sensing control line SCL and the third subpixel SP3 and the fourth subpixel SP4 are at a second side of the sensing control line SCL that is opposite the first side in a plan view of the display device.

Also, a reference line RL extends in the second direction between the first column and the second column. That is, the reference line RL is between the first and second subpixels SP1 and SP2 and between the third and fourth subpixels SP3 and SP4. In other words, the reference line RL is between a first pair of subpixels disposed along the vertical direction (e.g., the first subpixel SP1 and the third subpixel SP3) and a second pair of subpixels disposed along the vertical direction (e.g., the second subpixel SP2 and the fourth subpixel SP4). In one embodiment, the first subpixel SP1 and the third subpixel SP3 are at a first side of the reference line RL and the second subpixel SP2 and the fourth subpixel SP4 are at a second side of the reference line RL that is opposite the first side in the plan view of the display device.

Each of the first to fourth subpixels SP1, SP2, SP3, and SP4 includes a respective sensing thin film transistor T3. In this case, the sensing thin film transistor T3 is formed adjacent to a portion where the sensing control line SCL and the reference line RL cross each other.

The sensing thin film transistors T3 may be formed to overlap the sensing control line SCL and the reference line RL. The sensing thin film transistors T3 may be formed in a central portion of the pixel P. For example, the sensing thin film transistors T3 may be formed in a portion between the first subpixel SP1 and the fourth subpixel SP4 facing diagonally and formed in a portion between the second subpixel SP2 and the third subpixel SP3 facing diagonally.

As described above, according to one embodiment of the present disclosure, the sensing thin film transistor T3 of the plurality of subpixels SP1, SP2, SP3, and SP4 may be disposed to be in close contact with the central portion of the pixel P while being overlapped with the sensing control line SCL and the reference line RL, thereby minimizing a region for forming the sensing thin film transistor T3.

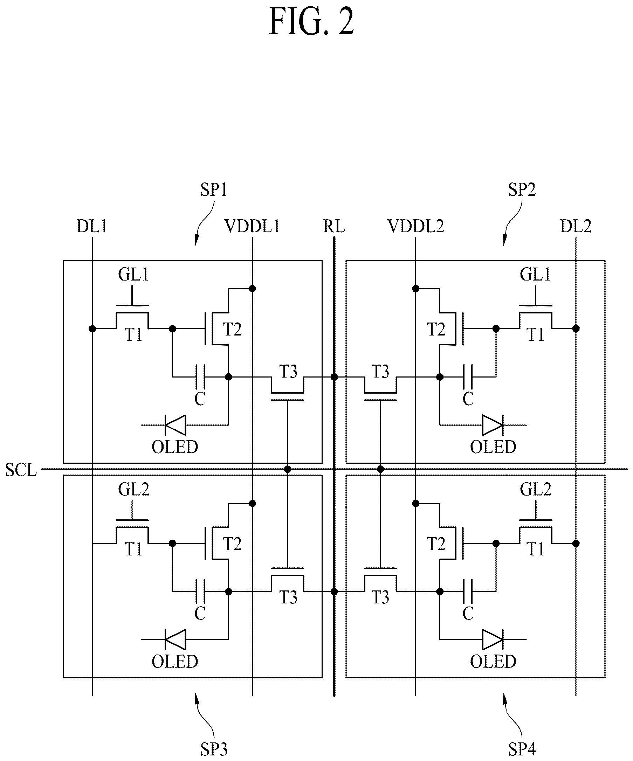

FIG. 2 is a circuit diagram of an electroluminescent display device according to one embodiment of the present disclosure, which is a circuit configuration diagram of first to fourth subpixels SP1, SP2, SP3, and SP4.

As shown in FIG. 2, the electroluminescent display device according to one embodiment of the present disclosure includes gate lines GL1 and GL2, a sensing control line SCL, high power lines VDDL1 and VDDL2, data lines DL1 and DL2, a reference line RL, a plurality of switching thin film transistors T1, a plurality of driving thin film transistors T2, a plurality of sensing thin film transistors T3, a plurality of capacitors C, and a plurality of organic light emitting elements (organic light emitting diode) OLED. Each subpixel SP1 includes a corresponding switching thin film transistor T1, a corresponding driving transistor T2, a corresponding sensing thin film transistor T3, a corresponding capacitor C, and a corresponding organic light emitting element OLED.

The gate lines GL1 and GL2 supply a gate signal to gate terminals of the switching thin film transistors T1 of the first to fourth subpixels SP1, SP2, SP3, and SP4.

For example, the first gate line GL1 may supply the gate signal to the gate terminal of the switching thin film transistors T1 of the first and second subpixels SP1 and SP2, and the second gate line GL2 may supply the gate signal to the gate terminal of the switching thin film transistors T1 of the third and fourth subpixels SP3 and SP4. However, the present disclosure is not limited thereto, and one gate line may be connected to the gate terminals of the switching thin film transistors T1 of the first to fourth subpixels SP1, SP2, SP3, and SP4.

The sensing control line SCL supplies a sensing control signal to gate terminals of the sensing thin film transistors T3 of the first to fourth subpixels SP1, SP2, SP3, and SP4. The first gate line GL1 or the second gate line GL2 may function as the sensing control line. In this case, a separate sensing control line SCL may not be provided.

The high power lines VDDL1 and VDDL2 supply a high power for driving the pixel to drain terminals of the driving thin film transistors T2 of the first to fourth subpixels SP1, SP2, SP3, and SP4. For example, the first high power line VDDL1 may supply the high power to the drain terminals of the driving thin film transistors T2 of the first and third subpixels SP1 and SP3, and the second high power line VDDL2 may supply the high power to the drain terminals of the driving thin film transistors T2 of the second and fourth subpixels SP2 and SP4. However, the present disclosure is not limited thereto, and one high power line may be connected to the drain terminal of the driving thin film transistor T2 of the first to fourth subpixels SP1, SP2, SP3, and SP4.

The data lines DL1 and DL2 supply a data signal to source terminals of the switching thin film transistors T1 of the first to fourth subpixels SP1, SP2, SP3, and SP4. For example, the first data line DL1 may supply the data signal to the source terminals of the switching thin film transistors T1 of the first and third subpixels SP1 and SP3, and the second data line DL2 may supply the data signal to the source terminals of the switching thin film transistors T1 of the second and fourth subpixels SP2 and SP4. However, the present disclosure is not limited thereto, and first to fourth data lines may be individually connected to the source terminals of the switching thin film transistors T1 of the first to fourth subpixels SP1, SP2, SP3, and SP4.

The reference line RL is connected to drain terminals of the sensing thin film transistors T3 of the first to fourth subpixels SP1, SP2, SP3, and SP4.

As the switching thin film transistors T1 of the first to fourth subpixels SP1, SP2, SP3, and SP4 are switched according to the gate signal supplied to the gate line GL1 and GL2, the switching thin film transistors T1 supply a data voltage supplied from the data line DL1 and DL2 to the driving thin film transistors T2 of the first to fourth subpixels SP1, SP2, SP3, and SP4.

As the driving thin film transistors T2 of the first to fourth subpixels SP1, SP2, SP3, and SP4 are switched according to the data voltage supplied from the switching thin film transistors T1 of the first to fourth subpixels SP1, SP2, SP3, and SP4, the driving thin film transistors T2 generate a data current from the high power supplied from the high power lines VDDL1 and VDDL2 and supply the data current to the organic light emitting element OLED of the first to fourth subpixels SP1, SP2, SP3, and SP4.

The sensing thin film transistors T3 of the first to fourth subpixels SP1, SP2, SP3, and SP4 may initialize a source terminal of the driving thin film transistor T2 of the first to fourth subpixels SP1, SP2, SP3, and SP4 to a reference voltage of the reference line RL in response to the sensing control signal supplied from the sensing control line SCL.

The capacitors C of the first to fourth subpixels SP1, SP2, SP3, and SP4 maintain the data voltage supplied to the driving thin film transistor T2 of the first to fourth subpixels SP1, SP2, SP3, and SP4 during one frame, and the capacitors C are connected to each of the gate terminal and the source terminal of the driving thin film transistor T2.

The organic light emitting elements OLED of the first to fourth subpixels SP1, SP2, SP3, and SP4 emit predetermined light according to the data current supplied from the driving thin film transistors T2 of the first to fourth subpixels SP1, SP2, SP3, and SP4. Each organic light emitting element OLED includes an anode, a cathode, and an emission layer provided between the anode and the cathode. The anode of each organic light emitting element OLED is connected to the source terminal of the corresponding driving thin film transistor T2, and the cathode of the organic light emitting element OLED is connected to a low power line. Although not shown, the low power line for supplying a low power to the cathode of the organic light emitting element OLED may be additionally provided.

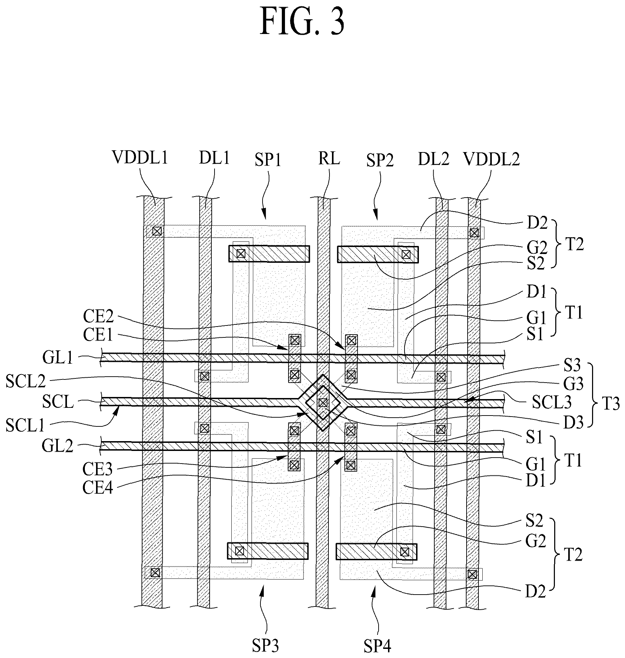

FIG. 3 is a plan view of an electroluminescent display device according to one embodiment of the present disclosure.

As shown in FIG. 3, the gate lines GL1 and GL2 and the sensing control line SCL extend in the first direction, for example, the horizontal direction.

The first gate line GL1 may be disposed at a first side of the sensing control line SCL, an upper side of the sensing control line SCL, and may be configured to supply the gate signal to the first and second subpixels SP1 and S2. The second gate line GL2 may be disposed at a second side of the sensing control line SCL, a lower side of the sensing control line SCL, and may be configured to supply the gate signal to the third and fourth subpixels SP3 and SP4. The first gate line GL1 confronts the second gate line GL2 with the sensing control line SCL interposed therebetween in a plan view of the display device.

The sensing control line SCL includes a first part SCL1, a second part SCL2, and a third part SCL3 disposed between the first part SCL1 and the second part SCL2 in the plan view of the display device.

The first part SCL1 and the third part SCL3 may be formed in the same pattern (e.g., shape) as a straight line, and the second part SCL2 may be formed in a different pattern (e.g., shape) from the first part SCL1 and the third part SCL3. For example, a width of the second part SCL2 is different from a width of the first part SCL1 and a width of the third part SCL3 in the plan view. The width of the second part SCL2 is greater than the width of the first part SCL1 and the width of the third part SCL3 in the plan view. The width of the first part SCL1 and the width of the third part SCL3 are the same in one embodiment. In another example, the first part SCL1 and the third part SCL3 extend in the first direction and are aligned with each other, and the second part SCL2 is not extending in the first direction and is not aligned to the first part SCL1 and the third part SCL3. Also, the first part SCL1 and the third part SCL3 are parallel to the gate lines GL1 and GL2, and the second part SCL2 is not parallel to the gate lines GL1 and GL2. In addition, a portion of the second part SCL2 may overlap the reference line RL, which will be described later. The first part SCL1 is connected to a first side of the second part SCL2, for example, the left side of the second part SCL2, and the third part SCL3 is connected to a second side of the second part SCL2, for example, the right side of the second part SCL2. The first part SCL1, the second part SCL2, and the third part SCL3 may be integrally formed as one body.

According to one embodiment of the present disclosure, the second part SCL2 may be configured to have a shape such as diamond shape and overlapping with the reference line RL, to thereby form the third gate electrode G3 of the sensing thin film transistors T3 of the first to fourth subpixels SP1, SP2, SP3, and SP4.

The first gate line GL1, the second gate line GL2, and the sensing control line SCL may be formed of the same material in the same layer.

The data lines DL1 and DL2, the high power lines VDDL1 and VDDL2, and the reference line RL may be arranged in the second direction crossing the first direction, for example, a vertical direction.

The data lines DL1 and DL2 supply the data signal to the first to fourth subpixels SP1, SP2, SP3, and SP4. For example, the first data line DL1 may supply the data signal to the first and third subpixels SP1 and SP3, and the second data line DL2 may supply the data signal to the second and fourth subpixels SP2 and SP4.

The high power lines VDDL1 and VDDL2 may be arranged adjacent to the data lines DL1 and DL2. For example, the first high power line VDDL1 may be arranged to be adjacent to the first data line DL1 at the left side of the first data line DL1, and the second high power line VDDL2 may be arranged adjacent to the second data line DL2 at the right side of the second data line DL2. In this specification, the fact that two lines are adjacent to each other means that no other lines are arranged between them.

The reference line RL may be arranged between the first subpixel SP1 and the second subpixel SP2 and between the third subpixel SP3 and the fourth subpixel SP4. The reference line RL may be arranged between the first data line DL1 and the second data line DL2.

The data lines DL1 and DL2, the high power lines VDDL1 and VDDL2, and the reference line RL may be formed of the same material in the same layer, but not limited thereto. For example, the data lines DL1 and DL2, the high power lines VDDL1 and VDDL2, and the reference line RL may be positioned above the gate lines GL1 and GL2 and the sensing control line SCL with an insulating layer interposed therebetween.

The first and third subpixels SP1 and SP3 may be provided between the first data line DL1 and the reference line RL in the plan view of the display device, and second and fourth subpixels SP2 and SP4 may be provided between the second data line DL2 and the reference line RL in the plan view of the display device.

In this case, the first subpixel SP1 may confront the second subpixel SP2 with the reference line RL interposed therebetween, and the third subpixel SP3 may confront the fourth subpixel SP4 with the reference line RL interposed therebetween.

Also, the first subpixel SP1 may confront the third subpixel SP3 with the gate line GL1 and GL2 or the sensing control line SCL interposed therebetween, and the second subpixel SP2 may confront the fourth subpixel SP4 with the gate line GL1 and GL2 or the sensing control line SCL interposed therebetween.

Each of the first to fourth subpixels SP1, SP2, SP3, and SP4 includes a switching thin film transistor T1, a driving thin film transistor T2, and a sensing thin film transistor T3.

The switching thin film transistor T1 includes a first gate electrode G1, a first source electrode S1, and a first drain electrode D1.

The first gate electrode G1 may be a portion of one of the gate lines GL1 and GL2 depending on which of the subpixels that the switching thin film transistor T1 is included. For example, the first gate electrode G1 of the switching thin film transistor T1 that is included in the second subpixel SP2 is a portion of the gate line GL1 whereas the first gate electrode G1 of the switching thin film transistor T1 that is included in the fourth subpixel SP4 is a portion of the second gate line GL2.

The first source electrode S1 may be connected to the data line DL1 and DL2 through a contact hole at one side of the first gate electrode G1. In some cases, the data lines DL1 and DL2 may function as the first source electrode.

The first drain electrode D1 may be connected to a second gate electrode G2 of the driving thin film transistor T2 through a contact hole at the other side of the first gate electrode G1.

Although not shown, a first channel layer of the switching thin film transistor T1 formed of a semiconductor layer may be formed in a portion overlapped with the first gate electrode G1.

The driving thin film transistor T2 includes a second gate electrode G2, a second source electrode S2, and a second drain electrode D2.

The second gate electrode G2 may be connected to the first drain electrode D1 of the switching thin film transistor T1. The second gate electrode G2 may be formed of the same material in the same layer as the first gate electrode G 1, but not limited thereto. In some cases, the second gate electrode G2 may function as the first drain electrode D1.

The second source electrode S2 may be connected to a connection electrode CE1, CE2, CE3, and CE4 through a contact hole at one side of the second gate electrode G2. Although not shown, the second source electrode S2 may be connected to the anode of the organic light emitting element through the contact hole. The connection electrode CE1, CE2, CE3, and CE4 may be formed of the same material in the same layer as at least one of the data line DL1 and DL2, the high power line VDDL1 and VDDL2, and the reference line RL.

The second drain electrode D2 may be connected to the high power line VDD1 and VDD2 through a contact hole at the other side of the second gate electrode G2. In some cases, the high power line VDDL1 and VDDL2 may function as the second drain electrode.

Although not shown, a second channel layer of the driving thin film transistor T2 formed of a semiconductor layer may be formed in a portion overlapped with the second gate electrode G2. The second channel layer may be formed on the same layer as the first channel layer, but not limited thereto. Also, although not shown, a light blocking layer may be formed under the second channel layer to block external light from being incident on the second channel layer.

In some cases, a configuration connected to the high power line VDDL1 and VDDL2 may function as a source electrode, and a configuration connected to the connection electrode CE1, CE2, CE3, and CE4 and the anode of the organic light emitting element may function as a drain electrode.

The sensing thin film transistor T3 includes a third gate electrode G3, a third source electrode S3, and a third drain electrode D3.

The third gate electrode G3 may be formed of the second part SCL2 of the sensing control line SCL. The third gate electrode G3 may be formed of the same material in the same layer as the first gate electrode G1 or the second gate electrode G2.

The third source electrode S3 may be connected to the connection electrode CE1, CE2, CE3, and CE4 through a contact hole at one side of the third gate electrode G3. The third source electrode S3 may be electrically connected to the second source electrode S2 through the connection electrode CE1, CE2, CE3, and CE4.

The third drain electrode D3 may be connected to the reference line RL through a contact hole at the other side of the third gate electrode G3. In some cases, the reference line RL may function as the third drain electrode.

Although not shown, a third channel layer of the sensing thin film transistor T3 formed of a semiconductor layer may be formed in a portion overlapped with the third gate electrode G3. The third channel layer may be formed on the same layer as the first channel layer or the second channel layer, but not limited thereto.

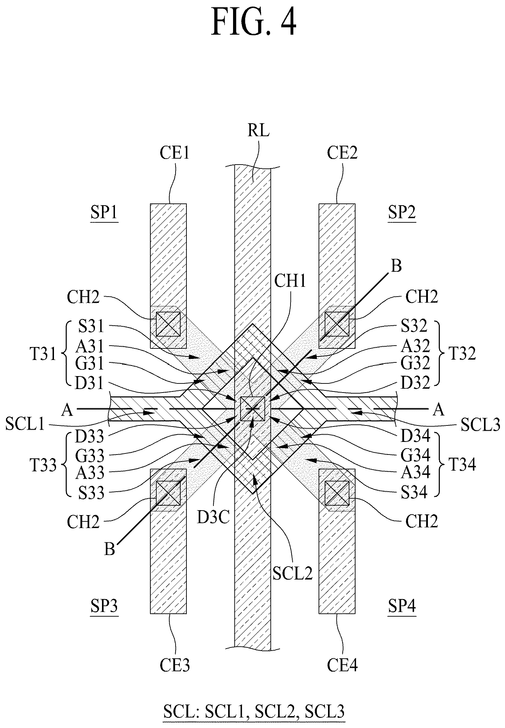

FIG. 4 is a plan view of an electroluminescent display device which relates to an example of a region of the sensing thin film transistor T3 of FIG. 3 according to one embodiment of the present disclosure,.

As shown in FIG. 4, the sensing control line SC extends in the first direction, and the reference line RL extends in the second direction. As described above, the sensing control line SCL includes a first part SCL1, a second part SCL2, and a third part SCL3 that is disposed between the first part SCL1 and the second part SCL2.

The first to fourth subpixels SP1, SP2, SP3, and SP4 are formed in respective regions defined by the sensing control line SCL and the reference line RL, and sensing thin film transistors T31, T32, T33, and T34 are respectively formed in the first to fourth subpixels SP1, SP2, SP3, and SP4. Specifically, the first sensing thin film transistor T31 is connected to the first connection electrode CE1 in the first subpixel SP1, the second sensing thin film transistor T32 is connected to the second connection electrode CE2 in the second subpixel SP2, the third sensing thin film transistor T33 is connected to the third connection electrode CE3 in the third subpixel SP3, and the fourth sensing thin film transistor T34 is connected to the fourth connection electrode CE4 in the fourth subpixel SP4.

The first sensing thin film transistor T31 and the fourth sensing thin film transistor T34 may be formed in a portion between the first subpixel SP1 and the fourth subpixel SP4 diagonally facing each other, and the second sensing thin film transistor T32 and the third sensing thin film transistor T33 may be formed in a portion between the second subpixel SP2 and the third subpixel SP3 diagonally facing each other.

The sensing thin film transistors T31, T32, T33, and T34 respectively include third gate electrodes G31, G32, G33, and G34, third source electrodes S31, S32, S33, and S34, third drain electrodes D31, D32, D33, and D34, and third channel layers A31, A32, A33, and A34.

The third gate electrode G31, G32, G33, and G34 may be formed as the second part SCL2 of the sensing control line SCL. For example, the (3-1)th gate electrode G31 of the first sensing thin film transistor T31 may be formed of the second part SCL2 of the sensing control line SCL extending to the first subpixel SP1, the (3-2)th gate electrode G32 of the second sensing thin film transistor T32 may be formed of the second part SCL2 of the sensing control line SCL extending to the second subpixel SP2, the (3-3)th gate electrode G33 of the third sensing thin film transistor T33 may be formed of the second part SCL2 of the sensing control line SCL extending to the third subpixel SP3, and the (3-4)th gate electrode G34 of the fourth sensing thin film transistor T34 may be formed of the second part SCL2 of the sensing control line SCL extending to the fourth subpixel SP4.

A first end of the (3-1)th gate electrode G31 may be connected to the first part SCL1 of the sensing control line SCL and a second end of the (3-1)th gate electrode G31 may be connected to a first end of the (3-2)th gate electrode G32. The first end of the (3-2)th gate electrode G32 may be connected to the second end of the (3-1)th gate electrode G31, and the second end of the (3-2)th gate electrode G32 may be connected to the third part SCL3 of the sensing control line SCL. A first end of the (3-3)th gate electrode G33 may be connected to the first part SCL1 of the sensing control line SCL and a second end of the (3-3)th gate electrode G33 may be connected to a second end of the (3-4)th gate electrode G34. The second end of the (3-4)th gate electrode G34 may be connected to the second end of the (3-3)th gate electrode G33 and a first end of the (3-4)th gate electrode G34 may be connected to the third part SCL3 of the sensing control line SCL.

Each of the (3-1)th gate electrode G31, the (3-2)th gate electrode G32, the (3-3)th gate electrode G33, and the (3-4)th gate electrode G34 may have a linear structure. The (3-1)th gate electrode G31 and the (3-3)th gate electrode G33 may be parallel to each other along a third direction (e.g., a first diagonal direction) that is different from the first direction (e.g., horizontal direction) and the second direction (e.g., vertical direction) while being confronted with each other. The (3-2)th gate electrode G32 and the (3-4)th gate electrode G34 may be parallel to each other along a fourth direction (e.g., a second diagonal direction) that is different from the first direction (e.g., horizontal direction), the second direction (e.g., vertical direction), and the third direction (e.g., the first diagonal direction) while being confronted with each other. In one embodiment, the third direction and fourth direction intersection each other. For example, the third direction and the fourth direction are separated by 90 degrees. Accordingly, the (3-1)th gate electrode G31, the (3-2)th gate electrode G32, the (3-3)th gate electrode G33, and the (3-4)th gate electrode G34 may form a diamond structure as a whole, and may be integrally formed as one body.

The third source electrode S31, S32, S33, and S34 may be formed between the third gate electrode G31, G32, G33, and G34 and the connection electrode CE1, CE2, CE3, and CE4.

For example, the (3-1)th source electrode S31 of the first sensing thin film transistor T31 may be connected to the first connection electrode CE1 of the first subpixel SP1, the (3-2)th source electrode S32 of the second sensing thin film transistor T32 may be connected to the second connection electrode CE2 of the second subpixel SP2, the (3-3)th source electrode S33 of the third sensing thin film transistor T33 may be connected to the third connection electrode CE3 of the third subpixel SP3, and the (3-4)th source electrode S34 of the fourth sensing thin film transistor T34 may be connected to the fourth connection electrode CE4 of the fourth subpixel SP4.

The third drain electrode D31, D32, D33, and D34 may be formed between the third gate electrode G31, G32, G33, and G34 and the reference line RL.

The (3-1)th drain electrode D31 of the first sensing thin film transistor T31, the (3-2)th drain electrode D32 of the second sensing thin film transistor T32, the (3-3)th drain electrode D33 of the third sensing thin film transistor T33, and the (3-4)th drain electrode D34 of the fourth sensing thin film transistor T34 may be connected to the reference line RL. For example, the (3-1)th drain electrode D31, the (3-2)th drain electrode D32, the (3-3)th drain electrode D33, and the (3-4)th drain electrode D34 may extend to one third drain electrode central part D3C, and the third drain electrode central part D3C may be connected to the reference line RL through a first contact hole CH1. The third drain electrode central part D3C may function as the (3-1)th drain electrode D31, the (3-2)th drain electrode D32, the (3-3)th drain electrode D33, and the (3-4)th drain electrode D34.

The (3-1)th drain electrode D31 and the (3-3)th drain electrode D33 face each other with respect to the third drain electrode central part D3C, and the (3-2)th drain electrode D32 and the (3-4)th drain electrode D34 face each other with respect to the third drain electrode central part D3C.

The plurality of third source electrodes S31, S32, S33, and S34 may be connected to the connection electrodes CE1, CE2, CE3, and CE4 through a plurality of second contact holes CH2, specifically, four of the separate second contact holes CH2, and the plurality of third drain electrodes D31, D32, D33, and D34 may be connected to the reference line RL through one of first contact hole CH1. Therefore, according to one embodiment of the present disclosure, one of the first contact hole CH1 and four of the second contact holes CH2 may be formed in one pixel.

The third channel layer A31, A32, A33, and A34 formed of a semiconductor layer is formed in a portion overlapped with the third gate electrode G31, G32, G33, and G34.

For example, the (3-1)th channel layer A31 of the first sensing thin film transistor T31 is overlapped with the (3-1)th gate electrode G31 and is formed between the (3-1)th source electrode S31 and the (3-1)th drain electrode D31, the (3-2)th channel layer A32 of the second sensing thin film transistor T32 is overlapped with the (3-2)th gate electrode G32 and is formed between the (3-2)th source electrode S32 and the (3-2)th drain electrode D32, the (3-3)th channel layer A33 of the third sensing thin film transistor T33 is overlapped with the (3-3)th gate electrode G33 and is formed between the (3-3)th source electrode S33 and the (3-3)th drain electrode D33, and the (3-4)th channel layer A34 of the fourth sensing thin film transistor T34 is overlapped with the (3-4)th gate electrode G34 and is formed between the (3-4)th source electrode S34 and the (3-4)th drain electrode D34.

Since the third gate electrode G31, G32, G33, and G34 is formed in a linear shape, the third channel layer A31, A32, A33, and A34 is also formed in a linear shape.

The (3-1)th source electrode S31, the (3-1)th channel layer A31, the (3-1)th drain electrode D31, the (3-4)th drain electrode D34, the (3-4)th channel layer A34, and the (3-4)th source electrode S34 may be continuously provided in this order while being disposed in a first line such as a first straight line in the plan view. The (3-1)th source electrode S31, the (3-1)th channel layer A31, the (3-1)th drain electrode D31, the (3-4)th drain electrode D34, the (3-4)th channel layer A34, and the (3-4)th source electrode S34 may have the same width, that is, first width. Herein, the first width corresponds to a width in a direction perpendicular to the extension direction of the first straight line.

Also, the (3-2)th source electrode S32, the (3-2)th channel layer A32, the (3-2)th drain electrode D32, the (3-3)th drain electrode D33, the (3-3)th channel layer A33, and the (3-3)th source electrode S33 may be continuously provided in this order while being formed in a second line such as a second straight line in the plan view. The (3-2)th source electrode S32, the (3-2)th channel layer A32, the (3-2)th drain electrode D32, the (3-3)th drain electrode D33, the (3-3)th channel layer A33, and the (3-3)th source electrode S33 may have the same width, that is, second width. Herein, the second width corresponds to a width in a direction perpendicular to the extension direction of the second straight line.

The first straight line and the second straight line may cross each other and may be provided in an X-shaped structure in a plan view of the display device.

As described above, according to one embodiment of the present disclosure, the first sensing thin film transistor T31 and the fourth sensing thin film transistor T34 may be continuously provided while being formed in a straight line, and the second sensing thin film transistor T32 and the third sensing thin film transistor T33 may be continuously provided while being formed in a straight line, thereby minimizing a region for forming the sensing thin film transistors T3.

In addition, according to one embodiment of the present disclosure, since the third drain electrodes D31, D32, D33, and D34 of the plurality of sensing thin film transistors T31, T32, T33, and T34 are integrally formed as one body, it is possible to minimize a region for forming the sensing thin film transistors T3.

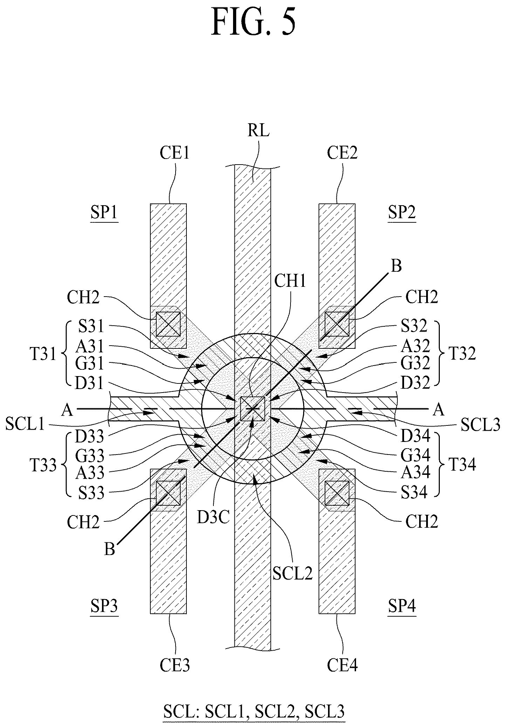

FIG. 5 is a plan view of an electroluminescent display device which relates to another example of a region of the sensing thin film transistor T3 of FIG. 3 according to another embodiment of the present disclosure.

FIG. 5 is the same as FIG. 4 except that the second part SCL2 of the sensing control line SCL is curved. Accordingly, the same reference numerals refer to like elements, and hereinafter, only different configurations will be described.

As shown in FIG. 5, the second part SCL2 of the sensing control line SCL may have a circular or oval shape in a plan view of the display device.

Accordingly, each of the (3-1)th gate electrode G31, the (3-2)th gate electrode G32, the (3-3)th gate electrode G33, and the (3-4)th gate electrode G34 may have a curved shape, and the (3-1)th gate electrode G31, the (3-2)th gate electrode G32, the (3-3)th gate electrode G33, and the (3-4)th gate electrode G34 may have a circular shape or an oval shape as a whole.

Since the third gate electrodes G31, G32, G33, and G34 are curved, the third channel layers A31, A32, A33, and A34 are also curved.

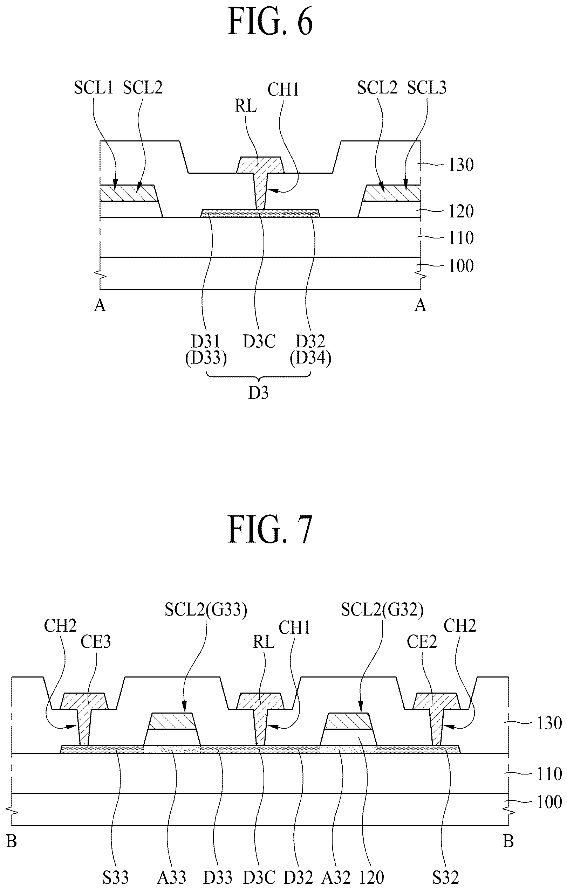

FIG. 6 is a cross-sectional view of an electroluminescent display device which is a cross-sectional view taken along line A-A of FIGs. 4 and 5 according to one embodiment of the present disclosure.

As shown in FIG. 6, the electroluminescent display device according to one embodiment of the present disclosure includes a substrate 100, a first insulating layer 110, a third drain electrode D3, a second insulating layer 120, sensing control lines SCL1, SCL2, and SCL3, a third insulating layer 130, and a reference line RL.

The substrate 100 may be formed of glass or plastic, but not limited thereto. The electroluminescent display device according to one embodiment of the present disclosure may be formed in a top emission type, whereby the substrate 100 may be formed of a transparent material as well as an opaque material.

The first insulating layer 110 is formed on the substrate 100. The first insulating layer 110 may be formed of an inorganic insulating material. The first insulating layer 110 may be formed of a plurality of layers.

The third drain electrode D3 may be formed on the first insulating layer 110. The third drain electrode D3 includes the third drain electrode central part D3C, the (3-1)th drain electrode D31 or (3-3)th drain electrode D33 positioned at one side of the third drain electrode central part D3C, and the (3-2)th drain electrode D32 or (3-4)th drain electrode D34 positioned at the other side of the third drain electrode central part D3C.

The third drain electrode central part D3C may overlap the first contact hole CH1 provided in the third insulating layer 130, and the (3-1)th drain electrode D31, the (3-2)th drain electrode D32, the (3-3)th drain electrode D33, and the (3-4)th drain electrode D34 may be integrally formed with the third drain electrode central part D3C.

The third drain electrode D3 may be formed by a selective conducting process of a semiconductor material, for example, oxide semiconductor. The selective conducting process may be performed by penetrating a conductive dopant into the semiconductor material. Therefore, the third drain electrode D3 may be formed of a conductive semiconductor layer, for example, a conductive oxide semiconductor layer.

The second insulating layer 120 may be patterned on the first insulating layer 110, and the sensing control line SCL1, SCL2, and SCL3 may be patterned on the second insulating layer 120. The second insulating layer 120 may serve as a gate insulating layer. The second insulating layer 120 and the sensing control line SCL1, SCL2, and SCL3 may be formed in the same pattern, but not limited thereto. The second insulating layer 120 may be made of an inorganic insulating material or may be formed of a plurality of layers.

One end of the second insulating layer 120 and one end of the second part SCL2 of the sensing control line SCL1, SCL2, and SCL3, which face one end of the third drain electrode D3, may be spaced apart from one end of the third drain electrode D3 by a predetermined interval without being overlapped with the third drain electrode D3. In addition, the other end of the second insulating layer 120 and the other end of the second part SCL2 of the sensing control line SCL1, SCL2, and SCL3, which face the other end of the third drain electrode D3, may be spaced apart from the other end of the third drain electrode D3 by a predetermined interval without being overlapped with the third drain electrode D3. The second insulating layer 120 may be formed in a pattern different from that of the sensing control line SCL1, SCL2, and SCL3 and may also be formed on the third drain electrode D3. In this case, except for the second insulating layer 120, one end and the other end of the second part SCL2 of the sensing control line SCL1, SCL2, and SCL3 facing the third drain electrode D3 may be spaced apart from each other by a predetermined interval without being overlapped with the third drain electrode D3.

The third insulating layer 130 is formed on the third drain electrode D3 and the sensing control line SCL1 and SCL3. The third insulating layer 130 may be made of an inorganic insulating material and may be formed of plurality of layers. The first contact hole CH1 may be provided in the third insulating layer 130, whereby the third drain electrode central part D3C may be exposed by the first contact hole CH1.

The reference line RL may be formed on the third insulating layer 130. The reference line RL is connected to the third drain electrode central part D3C through the first contact hole CH1 of the third insulating layer 130.

FIG. 7 is a cross-sectional view of an electroluminescent display device taken along line B-B of FIGs. 4 and 5 according to one embodiment of the present disclosure. Hereinafter, repeated descriptions of the same configuration as those of the above-described embodiment will be omitted.

As shown in FIG. 7, the electroluminescent display device according to one embodiment of the present disclosure includes a substrate 100, a first insulating layer 110, third source electrodes S32 and S33, third drain electrodes D32, D3C, and D33, third channel layers A32 and A33, a second insulating layer 120, third gate electrodes G32 and G33, a third insulating layer 130, a reference line RL, and connection electrodes CE2 and CE3. The third source electrodes S32 and S33, the third drain electrodes D32, D3C, and D33, and third channel layers A32 and A33 are in a same layer.

The first insulating layer 110 is formed on the substrate 100, and the third source electrodes S32 and S33, the third drain electrodes D32, D3C, and D33, and the third channel layers A32 and A33 are formed on the first insulating layer 110.

The third source electrodes S32 and S33 and the third drain electrodes D32, D3C, and D33 may be formed by a selective conducting process for a semiconductor material, for example, oxide semiconductor. That is, the third source electrodes S32 and S33 and the third drain electrodes D32, D3C, and D33 may be made of a conductive semiconductor layer, for example, a conductive oxide semiconductor layer.

The third channel layers A32 and A33 may be formed of a non-conductive semiconductor layer, for example, a non-conductive oxide semiconductor layer. The third channel layers A32 and A33 may be formed to have the same width as the third gate electrodes G32 and G33.

A selective conductive region for the non-conductive semiconductor layer may be the third source electrodes S32 and S33 and the third drain electrodes D32, D3C, and D33, and a non-conductive region may be the third channel layer A32 and A33.

The third source electrodes S32 and S33, the third drain electrodes D32, D3C, and D33, and the third channel layer A32 and A33 may be referred to as active layers. In this case, the connection electrode CE2 and CE3 connected to the third source electrode S32 and S33 may be referred to as a source electrode, and the reference line RL connected to the third drain electrode D32, D3C, and D33 may be referred to as a drain electrode.

The third source electrode S32 and S33, the third drain electrode D32, D3C, and D33, and the third channel layer A32 and A33 may have a multi-layered structure.

The second insulating layer 120 may be patterned on the third channel layer A32 and A33, and the third gate electrode G32 and G33 may be patterned on the second insulating layer 120.

The second insulating layer 120 may be formed in the same pattern as the third gate electrode G32 and G33, but not limited thereto. The second insulating layer 120 may be formed on the third source electrode S32 and S33 and the third drain electrode D32, D3C, and D33. In this case, the contact hole CH1, CH2, and CH3 may be also formed in the second insulating layer 120.

The third insulating layer 130 is formed on the third gate electrode G32 and G33, the third source electrode S32 and S33, and the third drain electrode D32, D3C, and D33. One of the first contact hole CH1 and the plurality of second contact holes CH2 are formed in the third insulating layer 130. The third drain electrode central part D3C may be exposed by the first contact hole CH1, and the plurality of third source electrodes, for example, the (3-2)th source electrode S32 and the (3-3)th source electrode S33 may be exposed by the second contact hole CH2.

The reference line RL and the connection electrodes CE2 and CE3 are formed on the third insulating layer 130.

The reference line RL may be connected to the third drain electrode central part D3C through the first contact hole CH1 of the third insulating layer 130, the second connection electrode CE2 may be connected to the (3-2)th source electrode S32 through one of the second contact hole CH2 of the third insulating layer 130, and the third connection electrode CE3 may be connected to the (3-3)th source electrode S33 through another second contact hole CH2 of the third insulating layer 130.

The reference line RL and the connection electrodes CE2 and CE3 may be formed of the same material in the same layer.

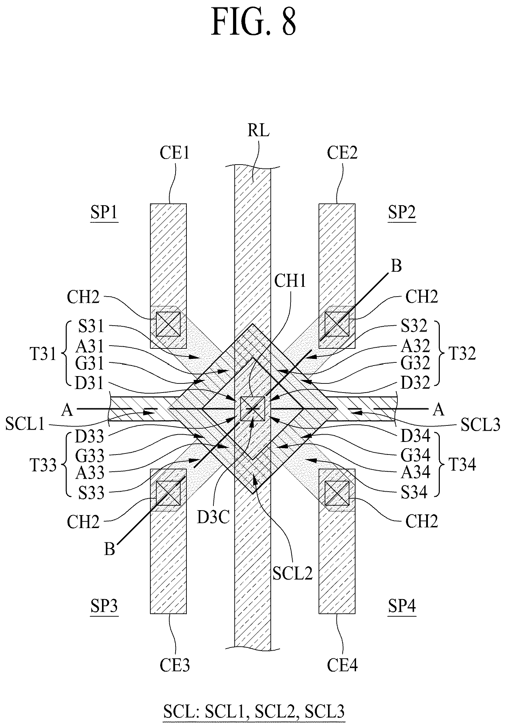

FIG. 8 is a plan view of an electroluminescent display device which relates to another example of a region of the sensing thin film transistor T3 of FIG. 3 according to another embodiment of the present disclosure.

Except that the configurations of the third drain electrodes D31, D32, D33, and D34 and the third channel layers A31, A32, A33, and A34 are changed, FIG. 8 is the same as FIG. 4. Accordingly, the same reference numerals refer to like elements, and hereinafter, only different configurations will be described.

In the case of the above-described FIG. 4, in each of the subpixels SP1, SP2, SP3, and SP4, the width of the third drain electrode D31, D32, D33, and D34 and the width of the third channel layer A31, A32, A33, and A34 are the same as the width of the third source electrode S31, S32, S33, and S34.

In contrast, in the case of FIG. 8, in each of the subpixels SP1, SP2, SP3, and SP4, the width of the third drain electrode D31, D32, D33, and D34 and the width of the third channel layer A31, A32, A33, and A34 may be greater than the width of the third source electrode S31, S32, S33, and S34.

Also, in the case of FIG. 4, a portion of the second part SCL2 of the diamond-shaped sensing control line SCL is overlapped with the third drain electrode D31, D32, D33, and D34, but another portion that is surrounded by the second part SCL2 of the diamond-shaped sensing control line SCL in the plan view is not overlapped (e.g., non-overlapping) with the third drain electrode D31, D32, D33, and D34.

In contrast, in FIG. 8, the entire portions surrounded by the second part SCL2 of the diamond-shaped sensing control line SCL in the plan view may overlap the third drain electrode D31, D32, D33, and D34.

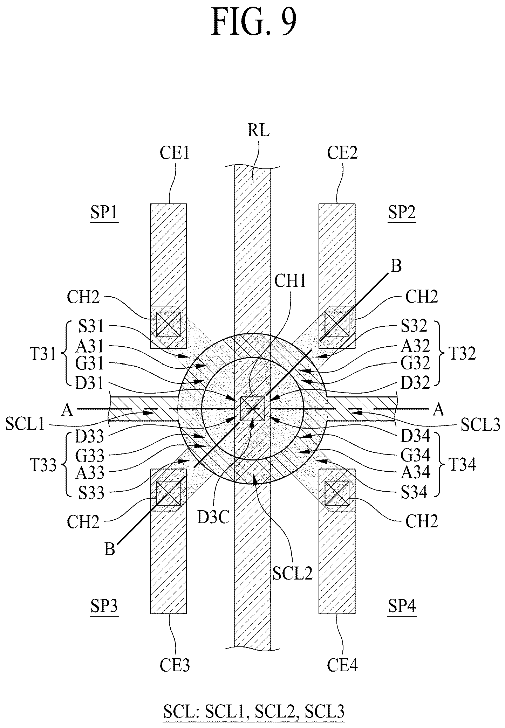

FIG. 9 is a plan view of an electroluminescent display device according to another embodiment of the present disclosure, which relates to another example of a region of the sensing thin film transistor T3 of FIG. 3.

Except that the configurations of the third drain electrodes D31, D32, D33, and D34 and the third channel layers A31, A32, A33, and A34 are changed, FIG. 9 is the same as FIG. 5. Accordingly, the same reference numerals refer to like elements, and hereinafter, only different configurations will be described.

In the above-described case of FIG. 5, in each of the subpixels SP1, SP2, SP3, and SP4, the width of the third drain electrode D31, D32, D33, and D34 and the width of the third channel layer A31, A32, A33, and A34 are the same as the width of the third source electrode S31, S32, S33, and S34.

In contrast, in FIG. 9, in each of the subpixels SP1, SP2, SP3, and SP4, the width of the third drain electrodes D31, D32, D33, and D34 and the width of the third channel layer A31, A32, A33, and A34 may be greater than the width of the third source electrode S31, S32, S33, and S34.

Also, in the case of FIG. 5, a portion that is surrounded by the second part SCL2 of the sensing control line SCL having the circular or elliptical structure is overlapped with the third drain electrode D31, D32, D33, and D34 in the plan view, but another portion that is surrounded by the second part SCL2 of the sensing control line SCL having the circular or elliptical structure is not overlapped with the third drain electrode D31, D32, D33, and D34.

In contrast, in FIG. 9, the entire portions that are surrounded by the second part SCL2 of the sensing control line SCL having the circular or elliptical structure may overlap the third drain electrode D31, D32, D33, and D34.

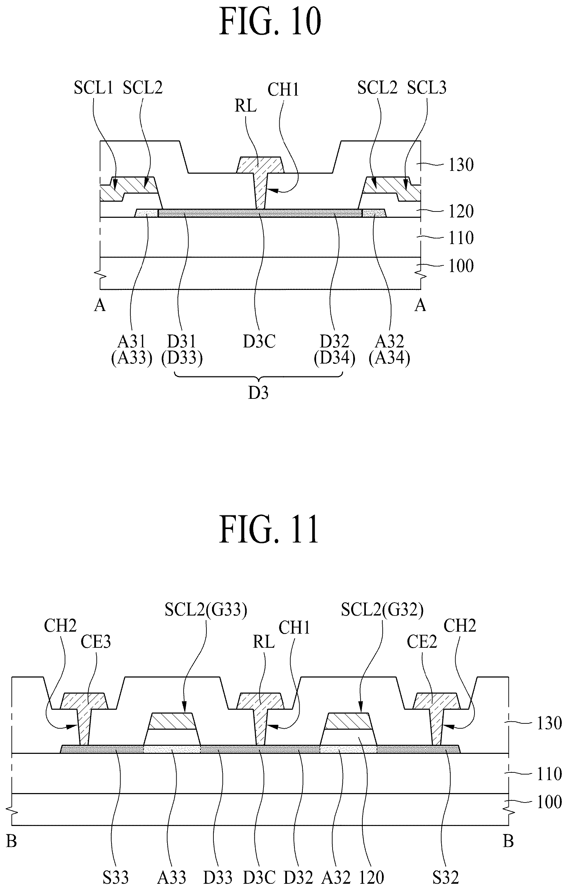

FIG. 10 is a cross-sectional view of an electroluminescent display device taken along line A-A of FIGs. 8 and 9 according to another embodiment of the present disclosure. Except that the configurations of the third drain electrode D3 and the third channel layer A31, A32, A33, and A34 are changed, FIG. 10 is the same as FIG. 6 described above. Accordingly, the same reference numerals refer to like elements, and hereinafter, only different configurations will be described.

As shown in FIG. 10, a first end of the third drain electrode D3 may coincide with a first end of the second part SCL2 of the sensing control line SCL1, SCL2, and SCL3 facing one end of the third drain electrode D3, and a second end of the third drain electrode D3 may coincide with a second end of the second part SCL2 of the sensing control line SCL1, SCL2, and SCL3 facing the other end of the third drain electrode D3. The first end and the second end of the third drain electrode D3 may extend below the lower surface of the second insulating layer 120 provided under the sensing control line SCL1, SCL2, and SCL3. That is, the first end and the second end of the drain electrode D3 are overlapped by the second insulating layer 120.

The (3-1)th channel layer A31 or the (3-3)th channel layer A33 may be connected to the first end of the third drain electrode D3, and (3-1)th channel layer A31 or the (3-3)th channel layer A33 may extend below the lower surface of the second insulating layer 120 such that the (3-1)th channel layer A31 or the (3-3)th channel layer A33 are overlapped by the second insulating layer 120 and the second part SCL2 of the sensing control line SCL1, SCL2, and SCL3. The (3-1)th channel layer A31 or the (3-3)th channel layer A33 may further extend below the lower surface of the second insulating layer 120 and may overlap the first part SCL1 of the sensing control line SCL1, SCL2, and SCL3.

Also, the (3-2)th channel layer A32 or the (3-4)th channel layer A34 may be connected to the other end of the third drain electrode D3, and the (3-2)th channel layer A32 or the (3-4)th channel layer A34 may extend below the lower surface of the second insulating layer 120 such that the (3-2)th channel layer A32 or the (3-4)th channel layer A34 are overlapped by the second insulating layer 120 and the second part SCL2 of the sensing control line SCL1, SCL2, and SCL3. The (3-2)th channel layer A32 or the (3-4)th channel layer A34 may further extend below the lower surface of the second insulating layer 120 and may overlap the third part SCL3 of the sensing control line SCL1, SCL2, and SCL3.

FIG. 11 is a cross-sectional view of an electroluminescent display device taken along line B-B of FIGs. 8 and 9 according to another embodiment of the present disclosure. FIG. 11 is the same as FIG. 7 described above, whereby repeated descriptions thereof will be omitted.

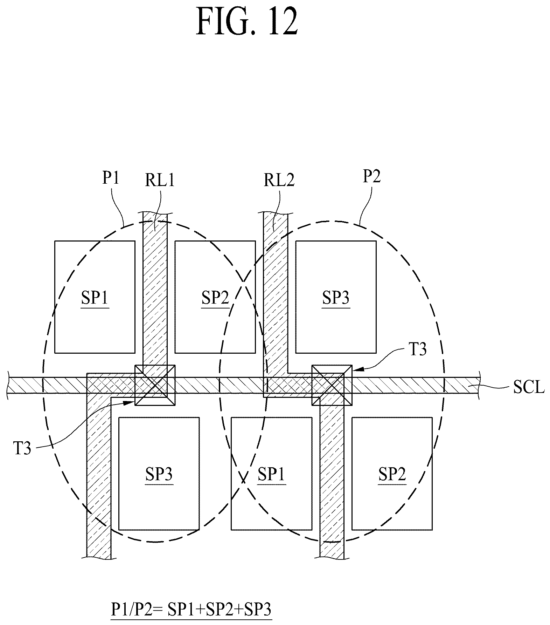

FIG. 12 is a schematic view of an electroluminescent display device according to another embodiment of the present disclosure.

As shown in FIG. 12, the electroluminescent display device according to another embodiment of the present disclosure includes a first pixel P1 and a second pixel P2.

Each of the first pixel P1 and the second pixel P2 includes a first subpixel SP1, a second subpixel SP2, and a third subpixel SP3. The first to third subpixels SP1, SP2, and SP3 may include a red subpixel, a green subpixel, and a blue subpixel.

In the case of the first pixel P1, the first subpixel SP1 and the second subpixel SP2 may be arranged along a first direction in a first row, for example the horizontal direction, and are at a first side of the sensing control line SCL. The third subpixel SP3 is at a second side of the sensing control line SCL in a portion of a second row at a location corresponding to a boundary between the first subpixel SP1 and the second subpixel SP2.

In the case of the second pixel P2, the first subpixel SP1 and the second subpixel SP2 may be arranged along the first direction of a second row, and the third subpixel SP3 may be formed in a portion of the first row corresponding to a boundary between the first subpixel SP1 and the second subpixel SP2.

In each of the pixels P1 and P2, between the first row and the second row, in other words, between the row where the first subpixel SP1 and the second subpixel SP2 are arranged and the row where the third subpixel SP3 is arranged, the sensing control line SCL extends in the first direction.

Also, in each of the pixels P1 and P2, a first portion of the reference line RL extends in the second direction, for example, vertical direction, between the first subpixel SP1 and the second subpixel SP2. A second portion of reference line RL that is connected to the first portion of the reference line RL may be bent and extends in the first direction (e.g., horizontal direction) to pass through a boundary between the third subpixel SP3 and a subpixel adjacent to the third subpixel SP3 without passing through the third subpixel SP3, but not limited thereto. A third portion of the reference line RL that is connected to the second portion of the reference line may extend in the second direction and may be formed in a straight line along the second direction while passing through the third subpixel SP3.

Each of the first to third subpixels SP1, SP2, and SP3 includes the sensing thin film transistor T3, and the sensing thin film transistor T3 is formed in a portion where the sensing control line SCL and the reference line RL cross each other.

The sensing thin film transistor T3 may be formed to overlap the sensing control line SCL and the reference line RL. The sensing thin film transistor T3 may be formed at a central portion in each of the pixels P1 and P2, that is, a central portion among the first subpixel SP1, the second subpixel SP2, and the third subpixel SP3.

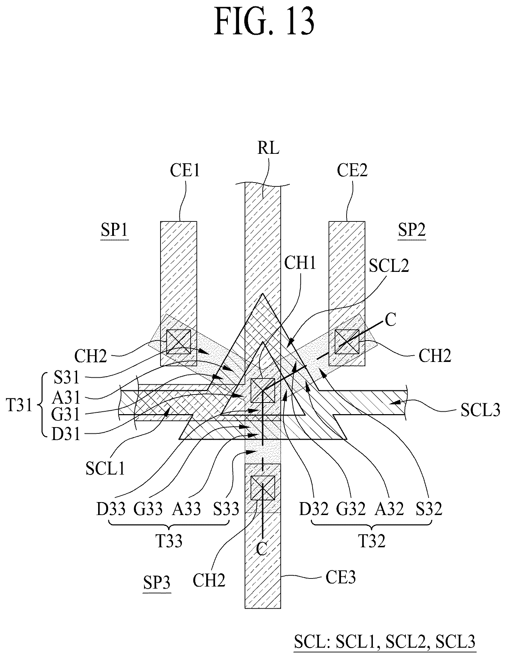

FIG. 13 is a plan view of an electroluminescent display device which relates to an example of a region of the sensing thin film transistor T3 of FIG. 12 according to another embodiment of the present disclosure. FIG. 13 is different from FIG. 4 in that the fourth subpixel SP4 is omitted. Hereinafter, repeated descriptions of the same configuration will be omitted, and the same components will be mainly described.

As shown in FIG. 13, a sensing control line SCL is formed to extend in the first direction, and a reference line RL is formed to extend in a structure being curved from the second direction to the first direction while being crossed with the sensing control line SCL.

The sensing control line SCL includes a first part SCL1, a second part SCL2, and a third part SCL3. In this case, the second part SCL2 of the sensing control line SCL may have a triangular shape.

First to third subpixels SP1, SP2, and SP3 are formed in respective regions defined by the sensing control line SCL and the reference line RL, and sensing thin film transistors T31, T32, and T33 are respectively formed in the first to third subpixels SP1, SP2, and SP3.

Specifically, the first sensing thin film transistor T31 is connected to a first connection electrode CE1 in the first subpixel SP1 provided at the upper left side of the sensing control line SCL, the second sensing thin film transistor T32 is connected to a second connection electrode CE2 in the second subpixel SP2 provided at the upper right side of the sensing control line SCL, and the third sensing thin film transistor T33 is connected to a third connection electrode CE3 in the third subpixel SP3 provided at the lower center of the sensing control line SCL. For example, in a plan view, the first sensing thin film transistor T31 may be arranged in a first diagonal direction from a left upper end to a right lower end between the first direction and the second direction, the second sensing thin film transistor T32 may be arranged in a second diagonal direction from a right upper end to a left lower end between the first direction and the second direction, and the third sensing thin film transistor T33 may be arranged in the second direction.

The sensing thin film transistor T31, T32, and T33 includes a third gate electrode G31, G32, and G33, a third source electrode S31, S32, and S33, a third drain electrode D31, D32, and D33, and a third channel layer A31, A32, and A33.

The (3-1)th gate electrode G31 of the first sensing thin film transistor T31 may be in contact with the first part SCL1 of the sensing control line SCL, and the (3-2)th gate electrode G32 of the second sensing thin film transistor T32 may be in contact with the third part SCL3 of the sensing control line SCL. The (3-3)th gate electrode G33 of the third sensing thin film transistor T33 may not be in contact with the sensing control line SCL, but not limited thereto.

Each of the (3-1)th gate electrode G31, the (3-2)th gate electrode G32, and the (3-3)th gate electrode G33 may have a straight-line structure, and the (3-1)th gate electrode G31, the (3-2)th gate electrode G32, and the (3-3)th gate electrode G33 may have a rectangular structure as a whole, and may be integrally formed with each other.

The third source electrode S31, S32, and S33 may be formed between the third gate electrode G31, G32, and G33 and the connection electrode CE1, CE2, and CE3, and may be connected to the connection electrode CE1, CE2, and CE3.

The third drain electrode D31, D32, and D33 may be formed between the third gate electrode G31, G32, and G33 and the reference line RL and may extend to one third drain electrode central part D3C and then converge at the third drain electrode central part D3C, and the third drain electrode central part D3C may be connected to the reference line RL through a contact hole.

The plurality of third source electrodes S31, S32, and S33 may be connected to the connection electrodes CE1, CE2, and CE3 through three of the second contact holes CH2, respectively, and the plurality of third drain electrodes D31, D32, and D33 may be connected to the reference line RL through one of the first contact hole CH1. Therefore, according to another embodiment of the present disclosure, one of the first contact hole CH1 and three of the second contact holes CH2 may be formed in one pixel.

The third channel layer A31, A32, and A33 of a semiconductor layer is formed in a portion overlapped with the third gate electrode G31, G32, and G33.

The (3-1)th source electrode S31, the (3-1)th channel layer A31, and the (3-1)th drain electrode D31 of the first sensing thin film transistor T31 form a first straight line, the (3-2)th source electrode S32, the (3-2)th channel layer A32, and the (3-2)th drain electrode D32 of the second sensing thin film transistor T32 form a second straight line, and the (3-3)th source electrode S33, the (3-3)th channel layer A33, and the (3-3)th drain electrode D33 of the third sensing thin film transistor T33 form a third straight line. One end of each of the first to third straight lines meets with one point, for example, the third drain electrode central part D3C, to thereby form a pinwheel structure having three wings with respect to one central point.

Although not shown, as described above in FIG. 5, the second part SCL2 of the sensing control line SCL may have a circular shape or oval shape. In this case, each of the (3-1)th gate electrode G31, the (3-2)th gate electrode G32, and the (3-3)th gate electrode G33 may be formed in a curved shape, and the (3-1)th gate electrode G31, the (3-2)th gate electrode G32, and the (3-3)th gate electrode G33 may have a circular shape or oval shape as a whole.

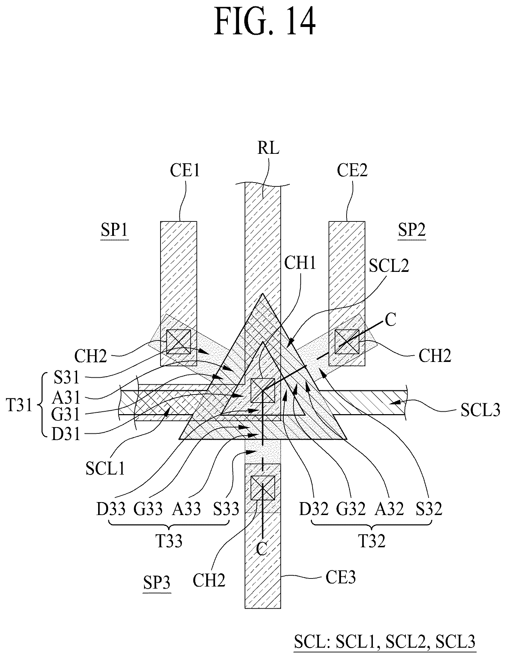

FIG. 14 is a plan view of an electroluminescent display device which relates to another example of a region of the sensing thin film transistor T3 of FIG. 12 according to another embodiment of the present disclosure.

FIG. 14 is the same as FIG. 13 except that the configurations of the third drain electrode D31, D32, and D33 and the third channel layer A31, A32, and A33 are changed.

In the case of FIG. 13, the width of the third drain electrode D31, D32, and D33 and the width of the third channel layer A31, A32, and A33 in each of the subpixels SP1, SP2, and SP3 are the same as the width of the third source electrode S31, S32, and S33.

In contrast, in the case of FIG. 14, the width of the third drain electrode D31, D32, and D33 and the width of the third channel layer A31, A32, and A33 in each of the subpixels SP1, SP2, and SP3 may be greater than the width of the third source electrode S31, S32, and S33.

Also, in FIG. 13, a portion that is surrounded by the second part SCL2 of the sensing control line SCL having the triangular structure overlaps the third drain electrode D31, D32 in the plan view, and D33, but another portion that is surrounded by the second part SCL2 of the sensing control line SCL having the triangular structure does not overlap the third drain electrode D31, D32, and D33 in the plan view.

In contrast, in FIG. 14, the entire portions that are surrounded by the second part SCL2 of the sensing control line SCL having the triangular structure in the plan view may overlap the third drain electrode D31, D32, and D33.

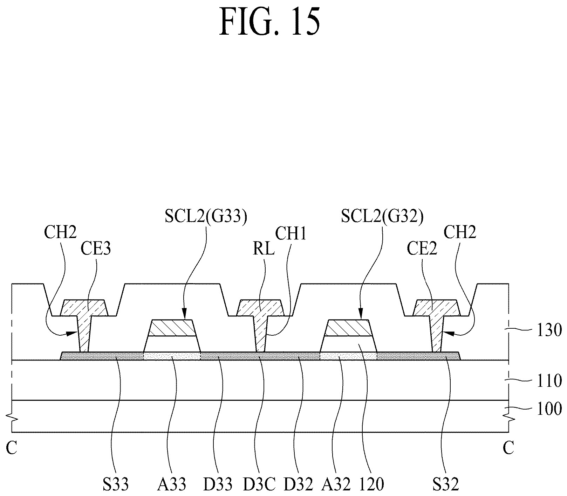

FIG. 15 is a cross-sectional view of an electroluminescent display device taken along line C-C of FIGs. 13 and 14 according to another embodiment of the present disclosure. FIG. 15 is the same as FIG. 7 described above, whereby a repeated description thereof will be omitted.

According to one embodiment of the present disclosure, the sensing thin film transistor T3 of the plurality of subpixels SP1, SP2, SP3, and SP4 is disposed at the center portion of the pixel P while being overlapped with the sensing control line SCL and the reference line RL, thereby minimizing the region for forming the sensing thin film transistor T3 and enabling the process optimization.

According to one embodiment of the present disclosure, the first sensing thin film transistor T31 and the fourth sensing thin film transistor T34 may be continuously provided while being formed in a straight line, and the second sensing thin film transistor T32 and the third sensing thin film transistor T33 may be continuously provided while being formed in a straight line, thereby minimizing the region for forming the sensing thin film transistor T3.

In addition, according to one embodiment of the present disclosure, since the third drain electrodes D31, D32, D33, and D34 of the plurality of sensing thin film transistors T31, T32, T33, and T34 are integrally formed (e.g., integral) as one body (e.g., a single body), thereby minimizing the region for forming the sensing thin film transistor T3.

In one embodiment, a display device comprises: a plurality of subpixels; a sensing control line extending in a first direction, the sensing control line between at least a first pair of subpixels among the plurality of subpixels in a plan view of the display device; a reference line extending in a second direction that crosses the first direction, the reference line between at least a second pair of subpixels among the plurality of subpixels in the plan view; and a plurality of sensing thin film transistors included in the plurality of subpixels, the plurality of sensing thin film transistors connected to the sensing control line and the reference line, wherein the plurality of sensing thin film transistors overlap the sensing control line and the reference line in the plan view.

In one embodiment, the sensing control line comprises: a first part; a second part connected to the first part, and a third part connected to the second part, wherein a pattern of the second part is different from the first part and the third part and the second part includes a plurality of gate electrodes of the plurality of sensing thin film transistors.

In one embodiment, a portion of the second part of the sensing control line overlaps the reference line.

In one embodiment, the pattern of the second part has one of a diamond shape, a circular shape, an oval shape, or a triangular shape.

In one embodiment, drain electrodes of the plurality of sensing thin film transistors converge at one drain electrode central part that is connected to the reference line through a contact hole.

In one embodiment, the plurality of subpixels include a first subpixel and a second subpixel arranged along the first direction at a first side of the sensing control line and a third subpixel and a fourth subpixel arranged along the first direction at a second side of the sensing control line that is opposite the first side in the plan view of the display device, and wherein the plurality of sensing thin film transistors include a first sensing thin film transistor in the first subpixel, a second sensing thin film transistor in the second subpixel, a third sensing thin film transistor in the third subpixel, and a fourth sensing thin film transistor in the fourth subpixel.

In one embodiment, a source electrode, a channel layer, and a drain electrode in the first sensing thin film transistor, and a drain electrode, a channel layer, and a source electrode in the fourth sensing thin film transistor are disposed in a first line in the plan view.

In one embodiment, a source electrode, a channel layer, and a drain electrode in the second sensing thin film transistor, and a drain electrode, a channel layer, and a source electrode in the third sensing thin film transistor are disposed in a second line that crosses the first line in the plan view.

In one embodiment, the plurality of subpixels include a first subpixel and a second subpixel arranged along the first direction at a first side of the sensing control line and a third subpixel at a second side of the sensing control line at a location corresponding to a boundary between the first subpixel and the second subpixel, and the plurality of sensing thin film transistors include a first sensing thin film transistor in the first subpixel, a second sensing thin film transistor in the second subpixel, and a third sensing thin film transistor in the third subpixel.

In one embodiment, a source electrode, a channel layer, and a drain electrode in the first sensing thin film transistor are disposed in a first line in the plan view, wherein a source electrode, a channel layer, and a drain electrode in the second sensing thin film transistor are disposed in a second line in the plan view, wherein a drain electrode, a channel layer, and a source electrode in the third sensing thin film transistor are disposed in a third line in the plan view, wherein the first line, the second line, and the third line converge at a central point in the plan view.

In one embodiment, the plurality of sensing thin film transistors include a first sensing thin film transistor in the first subpixel that includes a drain electrode, a source electrode, and a channel layer, and a width of the source electrode, a width of the channel layer, and a width of the drain electrode are the same (in other words, equal).

In one embodiment, the plurality of sensing thin film transistors include a first sensing thin film transistor in the first subpixel that has a drain electrode, a source electrode, and a channel layer, and a width of the channel layer and a width of the drain electrode is greater than a width of the source electrode.

In one embodiment, the plurality of sensing thin film transistors include a plurality of drain electrodes that are connected to the reference line through a first contact hole, a plurality of source electrodes that are connected to a plurality of connection electrodes through a plurality of second contact holes, and a plurality of channel layers, wherein the plurality of connection electrodes and the reference line include a same material and are disposed on a same insulating layer.

In one embodiment, a display device comprises: a pixel including a plurality of subpixels; a sensing control line extending in a first direction, the sensing control line between at least a first pair of subpixels among the plurality of subpixels in a plan view of the display device; a reference line extending in a second direction that crosses the first direction, the reference line between at least a second pair of subpixels among the plurality of subpixels in the plan view; and a plurality of sensing thin film transistors included in the plurality of subpixels, the plurality of sensing thin film transistors connected to the sensing control line and the reference line, wherein the plurality of sensing thin film transistors are located in a central portion of the pixel in the plan view.

In one embodiment, each of the plurality of sensing thin film transistors includes a drain electrode that is electrically connected to the reference line, and drain electrodes of the plurality of sensing thin film transistors converge at a drain electrode central part that is connected to the reference line.

In one embodiment, the plurality of subpixels include a first subpixel and a second subpixel arranged along the first direction at a first side of the sensing control line and a third subpixel and a fourth subpixel arranged along the first direction at a second side of the sensing control line that is opposite the first side in the plan view of the display device, wherein the plurality of sensing thin film transistors include a first sensing thin film transistor in the first subpixel, a second sensing thin film transistor in the second subpixel, a third sensing thin film transistor in the third subpixel, and a fourth sensing thin film transistor in the fourth subpixel, wherein the first sensing thin film transistor and the fourth sensing thin film transistor are located in a portion between the first subpixel and the fourth subpixel and face each other along a first diagonal direction in the plan view, and the second sensing thin film transistor and the third sensing thin film transistor are located in a portion between the second subpixel and the third subpixel that diagonally face each other along a second diagonal direction that is different from the first diagonal direction in the plan view.

In one embodiment, the first sensing thin film transistor and the fourth sensing thin film transistor are disposed along a first line and the second sensing thin film transistor and the third sensing thin film transistor are disposed along a second line that intersects the first line in the plan view.

In one embodiment, the plurality of subpixels include a first subpixel and a second subpixel arranged in the first direction at a first side of the sensing control line and a third subpixel at a second side of the sensing control line at a location corresponding to a boundary between the first subpixel and the second subpixel, the plurality of sensing thin film transistors include a first sensing thin film transistor in the first subpixel, a second sensing thin film transistor in the second subpixel, and a third sensing thin film transistor in the third subpixel, and wherein the first sensing thin film transistor is disposed along a first diagonal direction between the first direction and the second direction, the second sensing thin film transistor is arranged in a second diagonal direction between the first direction and the second direction that is different from the first diagonal direction, and the third sensing thin film transistor is disposed along the second direction.

In one embodiment, the plurality of sensing thin film transistors include a plurality of drain electrodes that are electrically connected to the reference line, wherein the sensing control line includes a first part, a second part connected to the first part, and a third part connected to the second part, and wherein a first portion of the second part overlaps the plurality of drain electrodes and a location surrounded by the second part in the plan view is non-overlapping with the plurality of drain electrodes.

In one embodiment, the plurality of sensing thin film transistors include a plurality of drain electrodes electrically connected to the reference line, wherein the sensing control line includes a first part, a second part connected to the first part, and a third part connected to the second part, and portions surrounded by the second part in the plan view overlap the plurality of drain electrodes.

In one embodiment, drain electrodes of the plurality of sensing thin film transistors are integral with each other as a single body.

In one embodiment, a display device comprises: a pixel including a plurality of subpixels; a sensing control line extending in a first direction and between at a first pair of subpixels among the plurality of subpixels in a plan view of the display device, the sensing control line including a first part, a third part, and a second part that is between the first part and the third part and connected to the first part and the third part; and a reference line extending in a second direction that crosses the first direction, the reference line between a second pair of subpixels among the plurality of subpixels in the plan view, wherein a width of the second part in the plan view is different from a width of the first part and a width of the third part in the plan view.

In one embodiment, the width of the second part is greater than the width of the first part and the width of the third part.

In one embodiment, the width of the first part is a same as the width of the third part.

In one embodiment, a shape of the second part is one of a diamond shape, a circular shape, an oval shape, or a triangular shape.

In one embodiment, the display device further comprises: a plurality of sensing thin film transistors included in the plurality of subpixels, the plurality of sensing thin film transistors connected to the sensing control line and the reference line.

In one embodiment, the plurality of sensing thin film transistors overlap the second part of sensing control line and the reference line.

In one embodiment, the reference line overlaps the second part of the sensing control line in the plan view.

## Claims

1. A display device comprising:
a plurality of subpixels (SP1, SP2, SP3, SP4);
a sensing control line (SCL) extending in a first direction, the sensing control line (SCL) between at least a first pair of subpixels among the plurality of subpixels (SP1, SP2, SP3, SP4) in a plan view of the display device;
a reference line (RL) extending in a second direction that crosses the first direction, the reference line (RL) between at least a second pair of subpixels among the plurality of subpixels (SP1, SP2, SP3, SP4) in the plan view; and
a plurality of sensing thin film transistors (T3, T31, T32, T33, T34) included in the plurality of subpixels (SP1, SP2, SP3, SP4), the plurality of sensing thin film transistors (T3, T31, T32, T33, T34) connected to the sensing control line (SCL) and the reference line (RL),
wherein the plurality of sensing thin film transistors (T3, T31, T32, T33, T34) overlap the sensing control line (SCL) and the reference line (RL) in the plan view.

2. The display device of claim 1, wherein the sensing control line (SCL) comprises:
a first part (SCL1);
a second part (SCL2) connected to the first part (SCL1), and
a third part (SCL3) connected to the second part (SCL2),
wherein a pattern of the second part (SCL2) is different from the first part (SCL1) and the third part (SCL3), and wherein the second part (SCL2) includes a plurality of gate electrodes (G3, G31, G32, G33, G34) of the plurality of sensing thin film transistors (T3, T31, T32, T33, T34).

3. The display device of claim 2, wherein a portion of the second part (SCL2) of the sensing control line (SCL) overlaps the reference line (RL).

4. The display device of claim 2 or 3, wherein the pattern of the second part (SCL2) has one of a diamond shape, a circular shape, an oval shape, or a triangular shape.

5. The display device of any of claims 1 to 4, wherein drain electrodes (D3, D31, D32, D33, D34) of the plurality of sensing thin film transistors (T3, T31, T32, T33, T34) converge at one drain electrode central part (D3C) that is connected to the reference line (RL) through a contact hole (CH1).

6. The display device of any of claims 1 to 5, wherein the plurality of subpixels (SP1, SP2, SP3, SP4) include a first subpixel (SP1) and a second subpixel (SP2) arranged along the first direction at a first side of the sensing control line (SCL) and a third subpixel (SP3) and a fourth subpixel (SP4) arranged along the first direction at a second side of the sensing control line (SCL) that is opposite the first side in the plan view of the display device, and
wherein the plurality of sensing thin film transistors (T3, T31, T32, T33, T34) include a first sensing thin film transistor (T31) in the first subpixel (SP1), a second sensing thin film transistor (T32) in the second subpixel (SP2), a third sensing thin film transistor (T33) in the third subpixel (SP3), and a fourth sensing thin film transistor (T34) in the fourth subpixel (SP4).

7. The display device of claim 6, wherein a source electrode (S31), a channel layer (A31), and a drain electrode (D31) in the first sensing thin film transistor (T31), and a drain electrode (D34), a channel layer (A34), and a source electrode (S34) in the fourth sensing thin film transistor (T34) are disposed in a first line in the plan view.

8. The display device of claim 7, wherein a source electrode (S32), a channel layer (A32), and a drain electrode (D32) in the second sensing thin film transistor (T32), and a drain electrode (D33), a channel layer (A33), and a source electrode (S33) in the third sensing thin film transistor (T33) are disposed in a second line that crosses the first line in the plan view.

9. The display device of any of claims 1 to 5, wherein the plurality of subpixels (SP1, SP2, SP3) include a first subpixel (SP1) and a second subpixel (SP2) arranged along the first direction at a first side of the sensing control line (SCL) and a third subpixel (SP3) at a second side of the sensing control line (SCL) at a location corresponding to a boundary between the first subpixel (SP1) and the second subpixel (SP2), and
the plurality of sensing thin film transistors (T31, T32, T33) include a first sensing thin film transistor (T31) in the first subpixel (SP1), a second sensing thin film transistor (T32) in the second subpixel (SP2), and a third sensing thin film transistor (T33) in the third subpixel (SP3).

10. The display device of claim 9, wherein a source electrode (S31), a channel layer (A31), and a drain electrode (D31) in the first sensing thin film transistor (T31) are disposed in a first line in the plan view,
wherein a source electrode (S32), a channel layer (A32), and a drain electrode (D32) in the second sensing thin film transistor (T32) are disposed in a second line in the plan view,
wherein a drain electrode (D33), a channel layer (A33), and a source electrode (S33) in the third sensing thin film transistor (T33) are disposed in a third line in the plan view,
wherein the first line, the second line, and the third line converge at a central point in the plan view.

11. The display device of claim 9 or 10, wherein a width of a source electrode (S31), a width of a channel layer (A31), and a width of a drain electrode (D31) in the first sensing thin film transistor (T31) are the same.

12. The display device of claim 9 or 10, wherein a width of a channel layer (A31) and a width of a drain electrode (D31) of the first sensing thin film transistor (T31) are greater than a width of a source electrode (S31) in the first sensing thin film transistor (T31).

13. The display device of any of claims 1 to 4, wherein the plurality of sensing thin film transistors (T3, T31, T32, T33, T34) include a plurality of drain electrodes (D3, D31, D32, D33, D34) that are connected to the reference line (RL) through a first contact hole (CH1), a plurality of source electrodes (S3, S31, S32, S33, S34) that are connected to a plurality of connection electrodes (CE1, CE2, CE3, CE4) through a plurality of second contact holes (CH2), and a plurality of channel layers (A31, A32, A33, A34),
wherein the plurality of connection electrodes (CE1, CE2, CE3, CE4) and the reference line (RL) include a same material and are disposed on a same insulating layer.

14. The display device of claim 1, further comprising:
a pixel (P) including the plurality of subpixels (SP1, SP2, SP3, SP4);
wherein the plurality of sensing thin film transistors (T3, T31, T32, T33, T34) are located in a central portion of the pixel (P) in the plan view,
wherein, preferably, each of the plurality of sensing thin film transistors (T3, T31, T32, T33, T34) includes a drain electrode (D3, D31, D32, D33, D34) that is electrically connected to the reference line (RL), and drain electrodes (D3, D31, D32, D33, D34) of the plurality of sensing thin film transistors (T3, T31, T32, T33, T34) converge at a drain electrode central part (D3C) that is connected to the reference line (RL).

15. The display device of claim 14, wherein the plurality of subpixels (SP1, SP2, SP3, SP4) include a first subpixel (SP1) and a second subpixel (SP2) arranged along the first direction at a first side of the sensing control line (SCL) and a third subpixel (SP3) and a fourth subpixel (SP4) arranged along the first direction at a second side of the sensing control line (SCL) that is opposite the first side in the plan view of the display device,
wherein the plurality of sensing thin film transistors (T3, T31, T32, T33, T34) include a first sensing thin film transistor (T31) in the first subpixel (SP1), a second sensing thin film transistor (T32) in the second subpixel (SP2), a third sensing thin film transistor (T33) in the third subpixel (SP3), and a fourth sensing thin film transistor (T34) in the fourth subpixel (SP4),
wherein the first sensing thin film transistor (T31) and the fourth sensing thin film transistor (T34) are located in a portion between the first subpixel (SP1) and the fourth subpixel (SP4) and face each other along a first diagonal direction in the plan view, and the second sensing thin film transistor (T32) and the third sensing thin film transistor (T33) are located in a portion between the second subpixel (SP2) and the third subpixel (SP3) that diagonally face each other along a second diagonal direction that is different from the first diagonal direction in the plan view,
wherein, preferably, the first sensing thin film transistor (T31) and the fourth sensing thin film transistor (T34) are disposed along a first line and the second sensing thin film transistor (T32) and the third sensing thin film transistor (T33) are disposed along a second line that intersects the first line in the plan view.

## Amended claims

### Amended claims in accordance with Rule 137(2) EPC.

1. A display device comprising:
a plurality of subpixels (SP1, SP2, SP3, SP4);
a sensing control line (SCL) extending in a first direction, the sensing control line (SCL) between at least a first pair of subpixels among the plurality of subpixels (SP1, SP2, SP3, SP4) in a plan view of the display device;
a reference line (RL) extending in a second direction that crosses the first direction, the reference line (RL) between at least a second pair of subpixels among the plurality of subpixels (SP1, SP2, SP3, SP4) in the plan view; and
a plurality of sensing thin film transistors (T3, T31, T32, T33, T34) included in the plurality of subpixels (SP1, SP2, SP3, SP4), the plurality of sensing thin film transistors (T3, T31, T32, T33, T34) connected to the sensing control line (SCL) and the reference line (RL),
wherein the plurality of sensing thin film transistors (T3, T31, T32, T33, T34) overlap the sensing control line (SCL) and the reference line (RL) in the plan view,
wherein drain electrodes (D3, D31, D32, D33, D34) of the plurality of sensing thin film transistors (T3, T31, T32, T33, T34) extend to and converge at one drain electrode central part (D3C),
wherein an insulating layer (130) is formed on the drain electrode central part (D3C) and includes a first contact hole (CH1) exposing the drain electrode central part (D3C), and
wherein the reference line (RL) is formed on the insulating layer (130) and is electrically connected to the drain electrode central part (D3C) through the first contact hole (CH1).

2. The display device of claim 1, wherein the sensing control line (SCL) comprises:
a first part (SCL1);
a second part (SCL2) connected to the first part (SCL1), and
a third part (SCL3) connected to the second part (SCL2),
wherein a pattern of the second part (SCL2) is different from the first part (SCL1) and the third part (SCL3), and wherein the second part (SCL2) includes a plurality of gate electrodes (G3, G31, G32, G33, G34) of the plurality of sensing thin film transistors (T3, T31, T32, T33, T34).

3. The display device of claim 2, wherein a portion of the second part (SCL2) of the sensing control line (SCL) overlaps the reference line (RL).

4. The display device of claim 2 or 3, wherein the pattern of the second part (SCL2) has one of a diamond shape, a circular shape, an oval shape, or a triangular shape.

5. The display device of any of claims 1 to 4, wherein the plurality of subpixels (SP1, SP2, SP3, SP4) include a first subpixel (SP1) and a second subpixel (SP2) arranged along the first direction at a first side of the sensing control line (SCL) and a third subpixel (SP3) and a fourth subpixel (SP4) arranged along the first direction at a second side of the sensing control line (SCL) that is opposite the first side in the plan view of the display device, and
wherein the plurality of sensing thin film transistors (T3, T31, T32, T33, T34) include a first sensing thin film transistor (T31) in the first subpixel (SP1), a second sensing thin film transistor (T32) in the second subpixel (SP2), a third sensing thin film transistor (T33) in the third subpixel (SP3), and a fourth sensing thin film transistor (T34) in the fourth subpixel (SP4).

6. The display device of claim 5, wherein a source electrode (S31), a channel layer (A31), and the drain electrode (D31) in the first sensing thin film transistor (T31), and the drain electrode (D34), a channel layer (A34), and a source electrode (S34) in the fourth sensing thin film transistor (T34) are disposed in a first line in the plan view.

7. The display device of claim 6, wherein a source electrode (S32), a channel layer (A32), and the drain electrode (D32) in the second sensing thin film transistor (T32), and the drain electrode (D33), a channel layer (A33), and a source electrode (S33) in the third sensing thin film transistor (T33) are disposed in a second line that crosses the first line in the plan view.

8. The display device of any of claims 1 to 4, wherein the plurality of subpixels (SP1, SP2, SP3) include a first subpixel (SP1) and a second subpixel (SP2) arranged along the first direction at a first side of the sensing control line (SCL) and a third subpixel (SP3) at a second side of the sensing control line (SCL) at a location corresponding to a boundary between the first subpixel (SP1) and the second subpixel (SP2), and
the plurality of sensing thin film transistors (T31, T32, T33) include a first sensing thin film transistor (T31) in the first subpixel (SP1), a second sensing thin film transistor (T32) in the second subpixel (SP2), and a third sensing thin film transistor (T33) in the third subpixel (SP3).

9. The display device of claim 8, wherein a source electrode (S31), a channel layer (A31), and the drain electrode (D31) in the first sensing thin film transistor (T31) are disposed in a first line in the plan view,
wherein a source electrode (S32), a channel layer (A32), and the drain electrode (D32) in the second sensing thin film transistor (T32) are disposed in a second line in the plan view,
wherein the drain electrode (D33), a channel layer (A33), and a source electrode (S33) in the third sensing thin film transistor (T33) are disposed in a third line in the plan view,
wherein the first line, the second line, and the third line converge at a central point in the plan view.

10. The display device of claim 8 or 9, wherein a width of a source electrode (S31), a width of a channel layer (A31), and a width of the drain electrode (D31) in the first sensing thin film transistor (T31) are the same.

11. The display device of claim 8 or 9, wherein a width of a channel layer (A31) and a width of the drain electrode (D31) of the first sensing thin film transistor (T31) are greater than a width of a source electrode (S31) in the first sensing thin film transistor (T31).

12. The display device of any of claims 1 to 4, wherein the plurality of sensing thin film transistors (T3, T31, T32, T33, T34) further include a plurality of source electrodes (S3, S31, S32, S33, S34) that are connected to a plurality of connection electrodes (CE1, CE2, CE3, CE4) through a plurality of second contact holes (CH2), and a plurality of channel layers (A31, A32, A33, A34),
wherein the plurality of connection electrodes (CE1, CE2, CE3, CE4) and the reference line (RL) include a same material and are disposed on a same insulating layer.

13. The display device of claim 1, further comprising:
a pixel (P) including the plurality of subpixels (SP1, SP2, SP3, SP4);
wherein the plurality of sensing thin film transistors (T3, T31, T32, T33, T34) are located in a central portion of the pixel (P) in the plan view.

14. The display device of claim 13, wherein the plurality of subpixels (SP1, SP2, SP3, SP4) include a first subpixel (SP1) and a second subpixel (SP2) arranged along the first direction at a first side of the sensing control line (SCL) and a third subpixel (SP3) and a fourth subpixel (SP4) arranged along the first direction at a second side of the sensing control line (SCL) that is opposite the first side in the plan view of the display device,
wherein the plurality of sensing thin film transistors (T3, T31, T32, T33, T34) include a first sensing thin film transistor (T31) in the first subpixel (SP1), a second sensing thin film transistor (T32) in the second subpixel (SP2), a third sensing thin film transistor (T33) in the third subpixel (SP3), and a fourth sensing thin film transistor (T34) in the fourth subpixel (SP4),
wherein the first sensing thin film transistor (T31) and the fourth sensing thin film transistor (T34) are located in a portion between the first subpixel (SP1) and the fourth subpixel (SP4) and face each other along a first diagonal direction in the plan view, and the second sensing thin film transistor (T32) and the third sensing thin film transistor (T33) are located in a portion between the second subpixel (SP2) and the third subpixel (SP3) that diagonally face each other along a second diagonal direction that is different from the first diagonal direction in the plan view.

15. The display device of claim 14, wherein, the first sensing thin film transistor (T31) and the fourth sensing thin film transistor (T34) are disposed along a first line and the second sensing thin film transistor (T32) and the third sensing thin film transistor (T33) are disposed along a second line that intersects the first line in the plan view.
